# EUROPEAN PATENT APPLICATION

(11) **EP 4 787 378 A1**
(43) Date of publication of application: **05.08.2026**
(21) Application number: 25739694.5
(22) Date of filing: 12.05.2025
(51) Int. Cl.: G11C 29/12, G11C 29/20, G11C 29/18

(54) **INTERNAL ERROR CHECKING CIRCUIT AND MEMORY**

(30) Priority: 03.12.2024 CN 202411754887
(71) Applicant: CXMT Corporation, Hefei, Anhui 230601 (CN)
(72) Inventor: CAO, Kanyu, Hefei, Anhui 230601 (CN); GAO, Enpeng, Hefei, Anhui 230601 (CN); SUN, Jianpeng, Hefei, Anhui 230601 (CN)
(74) Representative: Gulde & Partner
(86) International application number: PCT/CN2025/094295
(87) International publication number: WO 2026/118379

(57) **Abstract**

An internal error-checking circuit includes a clock generation circuit, an internal command generation circuit, an address generation circuit, a control logic circuit, and an error correction circuit. The clock generation circuit generates and outputs a self-refresh clock signal in response to a self-refresh enable signal; the internal command generation circuit counts the self-refresh clock signals when the error-checking enable signal indicates that an internal error-checking function is enabled and generates and outputs one internal error-checking command signal when the count value of the self-refresh clock signal is a first preset value; the address generation circuit counts the internal error-checking command signal to generate and output an internal error-checking address; the control logic circuit controls, in response to the internal error-checking command signal, the error correction circuit to sequentially execute a single internal read-modify-write operation on the target memory cells corresponding to the internal error-checking address in a plurality of memory arrays.

## Description

### CROSS-REFERENCE TO RELATED APPLICATIONS

The present application claims priority to the Chinese Patent Application No. 202411754887.3, filed with China National Intellectual Property Administration on December 3, 2024, and entitled "INTERNAL ERROR-CHECKING CIRCUIT AND MEMORY". The abovereferenced application is incorporated herein by reference in its entirety.

### TECHNICAL FIELD

The present disclosure relates to the field of semiconductor technologies, and in particular, relates to an internal error-checking circuit and a memory.

### BACKGROUND

With the continuous development of semiconductor technology, there are increasingly higher demands for data transmission speed when manufacturing and using devices like computers. To achieve faster data transmission speeds, a series of dynamic random access memory devices (DRAM) capable of double data rate (Double Data Rate, DDR) transmission have emerged.

However, as the transmission speed of memory continues to increase, the process dimension of memory cells shrinks, and issues such as row hammer (Row hammer) arise, problems like charge leakage in DRAM memory have become more severe. This may increase the instability of data in the memory system and the potential error rate. Therefore, appropriate internal error-checking mechanisms are needed to periodically perform internal error checks on the memory and promptly correct detected errors, ensuring data integrity and system reliability.

### SUMMARY

Embodiments of the present disclosure provide an internal error-checking circuit and a memory.

In a first aspect, the embodiments of the present disclosure provide an internal error-checking circuit. The internal error-checking circuit includes: a clock generation circuit, an internal command generation circuit, an address generation circuit, a control logic circuit, and an error correction circuit. The clock generation circuit is configured to: generate and output a self-refresh clock signal in response to a self-refresh enable signal. The internal command generation circuit is configured to: receive the self-refresh clock signal and an error-checking enable signal, count the self-refresh clock signals when the error-checking enable signal indicates that an internal error-checking function is enabled, and generate and output one internal error-checking command signal when the count value of the self-refresh clock signal is a first preset value. The address generation circuit is configured to: receive the internal error-checking command signal and count the internal error-checking command signal to generate and output an internal error-checking address. The control logic circuit is configured to: receive the internal error-checking command signal and the internal error-checking address and control, in response to the internal error-checking command signal, the error correction circuit to sequentially execute a single internal read-modify-write operation on the target memory cells corresponding to the internal error-checking address in a plurality of memory arrays, where the plurality of memory arrays share the error correction circuit.

In some embodiments, the control logic circuit includes a plurality of memory array control circuits. The plurality of memory array control circuits correspond one-to-one with the plurality of memory arrays. Each of the plurality of memory array control circuits is configured to: receive the internal error-checking command signal and the internal error-checking address; sequentially generate a plurality of sets of internal signals in response to the internal error-checking command signal; and control, when the corresponding memory array is in an enabled state, the error correction circuit to perform a single internal read-modify-write operation on the target memory cell in the corresponding memory array based on one corresponding set of internal signals, where each of the plurality of sets of internal signals includes an internal read signal and an internal write signal.

In some embodiments, the error correction circuit is configured to: read stored data from the target memory cell based on the internal read signal and perform error checking and correction on the stored data to generate corrected data. The error correction circuit is further configured to write the corrected data into the target memory cell based on the internal write signal.

In some embodiments, the internal command generation circuit is further configured to: generate and output, when the error-checking enable signal indicates that the internal error-checking function is disabled, an internal self-refresh command signal in response to each pulse of the self-refresh clock signal; and generate and output one internal self-refresh command signal when the error-checking enable signal indicates that the internal error-checking function is enabled and the count value of the self-refresh clock signal is not the first preset value.

In some embodiments, the control logic circuit is further configured to: control the execution of a single self-refresh operation on all the memory arrays after controlling the error correction circuit to sequentially execute a single internal read-modify-write operation on the target memory cells corresponding to the internal error-checking address in the plurality of memory arrays.

In some embodiments, the address generation circuit includes a column-address generation circuit, a first decoding circuit, and a row-address generation circuit. The column-address generation circuit is configured to receive the internal error-checking command signal, perform column counting for the current memory row based on the internal error-checking command signal, and generate and output the target column address. The first decoding circuit is configured to decode the target column address and generate and output a column end signal when the target column address indicates that the column counting for the current memory row is completed. The row-address generation circuit is configured to receive the column end signal and the internal error-checking command signal and perform row counting on the memory arrays based on the column end signal to generate and output the target row address signal.

In some embodiments, the row-address generation circuit includes: a row counting circuit, configured to receive the column end signal and perform row counting on the memory array based on the column end signal, generating and outputting a row count value; and a row-address sampling circuit, configured to receive the internal error-checking command signal and the row count value and sample the row count value in response to the internal error-checking command signal, generating and outputting the target row address signal.

In some embodiments, the address generation circuit further includes a refresh-address generation circuit, configured to receive the internal self-refresh command signal and perform row counting on the memory arrays based on the internal self-refresh command signal to generate and output a self-refresh address. The control logic circuit is further configured to: control the execution of a single refresh operation on all the memory arrays based on the self-refresh address.

In some embodiments, the column-address generation circuit includes N cascaded first flip-flops, where N is an integer greater than or equal to one. The clock control terminal of the first flip-flop in a first stage serves as the input terminal of the column-address generation circuit and receives the internal error-checking command signal. The inverted output terminal of the first flip-flop in each stage is connected to the data input terminal of the first flip-flop; the clock control terminals of the other first flip-flops, except for the first flip-flop in the first stage, are all connected to the inverted output terminal of the first flip-flop in the preceding stage; the non-inverted output terminals of the N first flip-flops collectively output the target column address. The first decoding circuit includes a first NAND gate, with the N input terminals of the first NAND gate respectively connected to the non-inverted output terminals of the N first flip-flops, and the output terminal of the first NAND gate is configured to output the column end signal.

In some embodiments, the row counting circuit includes M cascaded second flip-flops, where M is an integer greater than or equal to one. The clock control terminal of the second flip-flop in the first stage serves as the input terminal of the row counting circuit and receives the column end signal. The inverted output terminal of the second flip-flop in each stage is connected to the data input terminal of the second flip-flop; the clock control terminals of the other second flip-flops, except for the second flip-flop in the first stage, are all connected to the inverted output terminal of the second flip-flop in the preceding stage; the non-inverted output terminals of the M second flip-flops collectively output the row count value. The row-address sampling circuit includes M third flip-flops; the clock control terminal of each of the M third flip-flops receives the internal error-checking command signal; the data input terminals of the M third flip-flops are connected to the non-inverted output terminals of the M second flip-flops in a one-to-one correspondence manner to receive the row count value; the non-inverted output terminals of the M third flip-flops collectively output the target row address.

In some embodiments, the memory array control circuit includes: a flag signal generation circuit, configured to receive the internal error-checking command signal and generate and output an operation flag signal at an active level in response to the internal error-checking command signal; and a read/write command generation circuit, configured to receive the operation flag signal and the internal error-checking command signal, and sequentially generate, in response to the internal error-checking command signal, a plurality of sets of internal signals while the operation flag signal is at the active level. The flag signal generation circuit is further configured to receive the internal write signal and set the operation flag signal to an inactive level when the count value of the internal write signal reaches a second preset value.

In some embodiments, the flag signal generation circuit includes: a command counting circuit, configured to count the inversion signal of the internal write signal to generate and output the count value of the internal write signal; a second decoding circuit, configured to receive the count value of the internal write signal and generate and output an operation end signal when the count value of the internal write signal is the second preset value; and an SR flip-flop, configured to receive the internal error-checking command signal and the operation end signal, set the operation flag signal to an active level in response to the internal error-checking command signal, and set the operation flag signal to an inactive level when the count value of the internal write signal reaches the second preset value.

In some embodiments, the read/write command generation circuit includes: a second NAND gate, where the first input terminal of the second NAND gate receives the operation flag signal, and the second input terminal of the second NAND gate receives the internal error-checking command signal; a first NOR gate, where the first input terminal of the first NOR gate is electrically connected to the output terminal of the second NAND gate, and the output terminal of the first NOR gate is configured to output the internal read signal; a second NOR gate, where the first input terminal of the second NOR gate is electrically connected to the output terminal of the first NOR gate, and the output terminal of the second NOR gate is electrically connected to the second input terminal of the first NOR gate; a delay unit, where the input terminal of the delay unit is electrically connected to the output terminal of the first NOR gate; a first NOT gate, where the input terminal of the first NOT gate is electrically connected to the output terminal of the delay unit, and the output terminal of the first NOT gate is electrically connected to the second input terminal of the second NOR gate; a second NOT gate, where the input terminal of the second NOT gate receives the operation flag signal; and a third NOR gate, where the first input terminal of the third NOR gate is electrically connected to the output terminal of the second NOT gate, the second input terminal of the third NOR gate is electrically connected to the output terminal of the first NOR gate, and the output terminal of the third NOR gate is configured to output the internal write signal.

In some embodiments, the memory array control circuit further includes: a self-refresh control circuit, configured to receive the operation flag signal and a self-refresh address, and control, when the operation flag signal flips to an inactive level, the corresponding memory array to perform a single refresh operation based on the self-refresh address.

In some embodiments, the error correction circuit is further configured to: generate and output, when executing an internal read-modify-write operation on the target memory cell, an error flag signal if there is an error in the stored data of the target memory cell. The internal error-checking circuit further includes: an error register, configured to receive the internal error-checking address and the error flag signal and store the internal error-checking address in response to the error flag signal.

In a second aspect, the embodiments of the present disclosure provide a memory. The memory includes the internal error-checking circuit as described in the first aspect.

The embodiments of the present disclosure provide an internal error-checking circuit and a memory. In the internal error-checking circuit, the internal command generation circuit is capable of "stealing" the current pulse of the self-refresh clock signal to generate an internal error-checking command signal when the error-checking enable signal indicates that the internal error-checking function is enabled and whenever the count value of the self-refresh clock signal reaches a first preset value. The control logic circuit is capable of, based on the internal error-checking command signal, reusing the original operation circuit and path for executing an external read-modify-write command and controlling the error correction circuit to sequentially perform a single internal read-modify-write operation on the target memory cells of a plurality of memory arrays that share the error correction circuit. The internal read-modify-write operation performed by the error correction circuit has the data error checking/correction function. In this way, the internal error-checking circuit can reuse the original clock generation circuit (configured for the self-refresh operation) and the operation circuit and path for executing the external read-modify-write command, without affecting the timing of the original self-refresh operation or external read-modify-write operation. Moreover, with only minor improvements to the original internal command generation circuit, address generation circuit, and control logic circuit, periodic data error checking/correction operations can be implemented across a plurality of memory arrays. Under the premise of implementing an internal error-checking mechanism to effectively enhance the stability of stored data, the design of the circuit is optimized, and the circuit area is saved.

### BRIEF DESCRIPTION OF DRAWINGS

FIG. 1 is a schematic diagram of the composition structure of an internal error-checking circuit according to an embodiment of the present disclosure;
FIG. 2 is a schematic diagram of the composition structure of a control logic circuit according to an embodiment of the present disclosure;
FIG. 3 is a schematic diagram of the composition structure of a memory region according to an embodiment of the present disclosure;
FIG. 4 is a first signal timing diagram corresponding to an internal error-checking circuit according to an embodiment of the present disclosure;
FIG. 5 is a schematic diagram of the composition structure of an address generation circuit according to an embodiment of the present disclosure;
FIG. 6 is a first signal timing diagram corresponding to an internal error-checking circuit according to an embodiment of the present disclosure;
FIG. 7 is a schematic diagram of the composition structure of a row-address generation circuit according to an embodiment of the present disclosure;
FIG. 8 is a schematic diagram of the composition structure of a column-address generation circuit according to an embodiment of the present disclosure;
FIG. 9 is a schematic diagram of the composition structure of a first decoding circuit according to an embodiment of the present disclosure;
FIG. 10 is a schematic diagram of the composition structure of a row counting circuit and a row-address sampling circuit according to an embodiment of the present disclosure;
FIG. 11 is a schematic diagram of the composition structure of a memory array control circuit according to an embodiment of the present disclosure;
FIG. 12 is a schematic diagram of the composition structure of a flag signal generation circuit according to an embodiment of the present disclosure;
FIG. 13 is a schematic diagram of the composition structure of another memory array control circuit according to an embodiment of the present disclosure;
FIG. 14 is a schematic diagram of the composition structure of a read/write command generation circuit according to an embodiment of the present disclosure;
FIG. 15 is a schematic diagram of the composition structure of another internal error-checking circuit according to an embodiment of the present disclosure; and
FIG. 16 is a schematic diagram of the composition structure of a memory according to an embodiment of the present disclosure.

### DESCRIPTION OF EMBODIMENTS

The technical solutions in embodiments of the present disclosure will be clearly and completely described below with reference to the drawings in the embodiments of the present disclosure. It can be understood that the specific embodiments described herein are merely for explaining the relevant disclosure and are not intended to limit this disclosure. In addition, it should be noted that for the convenience of description, only parts relevant to the related disclosure are shown in the drawings.

Unless otherwise defined, all technical and scientific terms used herein have the same meaning as commonly understood by those skilled in the art to which the present disclosure belongs. The terms used herein are for the purpose of describing the embodiments of the present disclosure only and are not intended to limit the present disclosure.

In the following description, reference is made to "some embodiments" which describe subsets of all possible embodiments, but it can be understood that "some embodiments" may be the same subset or different subsets of all possible embodiments, and may be combined with each other without conflict.

It should be noted that the terms "first\second\third" referred to in the embodiments of the present disclosure are merely used for distinguishing similar objects and do not represent a specific ordering for the objects. It is understandable that "first\second\third" may be subjected to interchange of a specific order or sequence if permitted, such that the embodiments of the present disclosure described herein can be implemented in an order other than that shown or described herein.

To establish an appropriate internal error-checking mechanism for periodically performing error checking/correction operations on a plurality of memory arrays (within the memory), the embodiments of the present disclosure provide an internal error-checking circuit that includes a clock generation circuit, an internal command generation circuit, an address generation circuit, a control logic circuit, and an error correction circuit. The clock generation circuit is configured to: generate and output a self-refresh clock signal in response to a self-refresh enable signal. The internal command generation circuit is configured to: receive the self-refresh clock signal and an error-checking enable signal, count (the pulses on) the self-refresh clock signal when the error-checking enable signal is at an active level, and generate and output one internal error-checking command signal when the count value of the self-refresh clock signal is a first preset value. The address generation circuit is configured to: receive the internal error-checking command signal and count the internal error-checking command signal to generate and output an internal error-checking address. The control logic circuit is configured to: receive the internal error-checking command signal and the internal error-checking address and control, in response to the internal error-checking command signal, the error correction circuit to sequentially execute a single internal read-modify-write operation on the target memory cells corresponding to the internal error-checking address in a plurality of memory arrays, where the plurality of memory arrays share the error correction circuit. In this way, when the error-checking enable signal indicates that the internal error-checking function is enabled and whenever the count value of the self-refresh clock signal reaches a first preset value, the internal command generation circuit is capable of "stealing" the current pulse on the self-refresh clock signal to generate an internal error-checking command signal. The control logic circuit is also capable of reusing the original circuit and path for executing an external read-modify-write command and, based on the internal error-checking command signal, controlling the error correction circuit to sequentially a single (internal) read-modify-write operation on the target memory cells of a plurality of memory arrays that share the error correction circuit. The internal read-modify-write operation performed by the error correction circuit has the data error checking/correction function. In this way, the internal error-checking circuit can reuse the original clock generation circuit (configured for the self-refresh operation) and the operation circuit and path for executing the external read-modify-write command, without affecting the timing of the original self-refresh operation or external read-modify-write operation. Moreover, with only minor improvements to the original internal command generation circuit, address generation circuit, and control logic circuit, periodic data error checking/correction operations can be implemented across a plurality of memory arrays. Under the premise of implementing an internal error-checking mechanism to effectively enhance the stability of stored data, the design of the circuit is optimized, and the circuit area is saved.

The embodiments of the present disclosure are described in detail below with reference to the drawings.

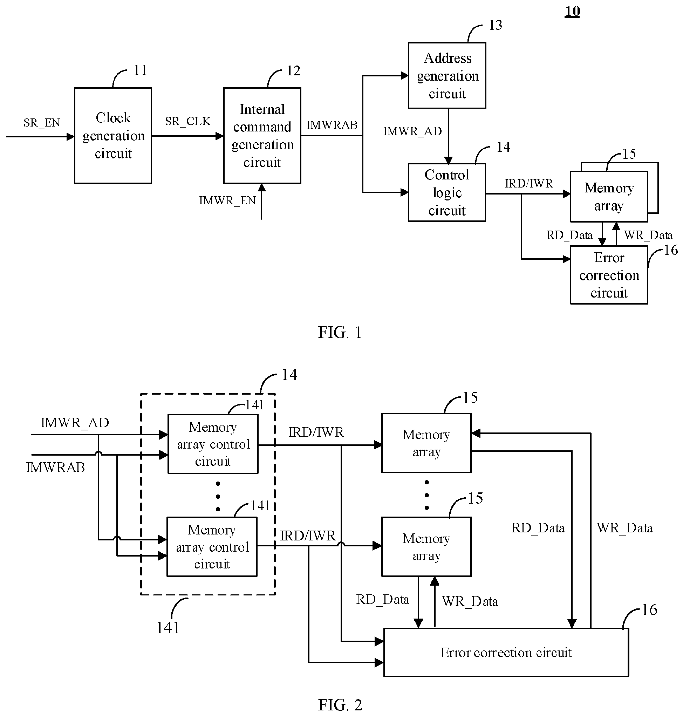

In an embodiment of the present disclosure, referring to FIG. 1, a schematic diagram of the composition structure of an internal error-checking circuit 10 according to an embodiment of the present disclosure is illustrated. As shown in FIG. 1, the internal error-checking circuit 10 includes: a clock generation circuit 11, an internal command generation circuit 12, an address generation circuit 13, a control logic circuit 14, and an error correction circuit 16.

The clock generation circuit 11 is configured to generate and output a self-refresh clock signal SR_CLK in response to the self-refresh enable signal SR_EN. The self-refresh clock signal SR_CLK has a first preset period.

The internal command generation circuit 12 is configured to: receive the self-refresh clock signal SR_CLK and an error-checking enable signal, count (the pulses on) the self-refresh clock signal SR_CLK when the error-checking enable signal indicates that the internal error-checking function is enabled, and generate and output one internal error-checking command signal IMWRAB when the count value of the self-refresh clock signal SR_CLK is a first preset value.

The address generation circuit 13 is configured to receive the internal error-checking command signal IMWRAB and count the internal error-checking command signal IMWRAB to generate and output an internal error-checking address IMWR_AD.

The control logic circuit 14 is configured to: receive the internal error-checking command signal IMWRAB and the internal error-checking address IMWR_AD, and control, in response to the internal error-checking command signal IMWRAB, the error correction circuit 16 to sequentially execute a single internal read-modify-write operation on the target memory cells corresponding to the internal error-checking address IMWR_AD in a plurality of memory arrays 15.

The plurality of memory arrays 15 share the error correction circuit 16.

It should be noted that the embodiments of the present disclosure relate to the overall circuit framework design of an internal error checking and correction mechanism, and in particular, relate to DRAM LPDDR series chips and DRAM DDR4 chips. Since the ECS function is only specified in the SPEC of DRAM DDR4 chips, but the SEPC of LPDDR series chips and DDR4 chips have not yet specified the ECS function and related requirements, the ECS function cannot be utilized to periodically (which may be every 12 hours/24 hours/48 hours, etc.) perform comprehensive error checking and clearing for such DRAM chips. Therefore, to implement an internal error checking and correction mechanism similar to the ECS function in such chips, it is necessary to complete the overall framework design of the internal error-checking circuit without affecting the original function and timing requirements of the DRAM chips. This internal error-checking circuit reuses the original clock generation circuit for a self-refresh operation, the path for a self-refresh command, and the operation circuit and path for executing an external read-modify-write command, without affecting the function or timing of the DRAM chip's original self-refresh operation or external read-modify-write operation. With only minor improvements to the original internal command generation circuit, address generation circuit, and control logic circuit, a periodic internal error checking and correction mechanism can be implemented. This internal error-checking circuit can be applied to DDR4 chips and LPDDR series chips but is not limited thereto. Other memory chips, as well as other internally generated commands, timing controls, and the like, may also adopt this design.

It should also be noted that in the related art when the external write command received by the DRAM chip is a partial write command (Masked Write, MWR), an external read-modify-write (Read-Modify-Write, RMW) operation is executed. The external read-modify-write operation can be decomposed into three operational steps: read, modify, and write back. Specifically, during the read step, the error correction circuit first reads stored data from the memory array; during the modify step, the error correction circuit modifies the read stored data based on the partial data to be written to generate write data and can generate new parity data based on the write data; during the write-back step, the error correction circuit stores the write data and the parity data. The internal error-checking circuit 10 according to the embodiments of the present disclosure reuses the relevant circuit and path of the original external read-modify-write operation of the DRAM chip and performs an internal read-modify-write operation on the stored data in the memory array to achieve the internal error checking/correction function. The internal read-modify-write operation can be decomposed into two operational steps: read-modify and write back. Specifically, during the read-modify step, the error correction circuit 16 reads stored data from the memory array 15 based on the internal read signal IRD and performs error checking and correction on the stored data based on parity data to generate corrected data; during the write step, the corrected data is written to the memory array based on the internal write signal IWR. Both the read and modify operations are completed during the effective period of the write command signal and should be considered part of the same operational step. From this, it can be understood that the internal read-modify-write operation in the embodiments of the present disclosure, although reusing the relevant circuit (error correction circuit 16) and paths (interaction paths among the control logic circuit 14, the error correction circuit 16, and the memory array 15) of the external read-modify-write operation, differs from the external read-modify-write operation. In the external read-modify-write operation, the modification refers to modifying the read stored data based on the partial data to be written, whereas in the internal read-modify-write operation, there is no externally inputted data to be written. Instead, the modification essentially refers to performing error checking and correction operations on the read stored data. In addition, performing a single internal read-modify-write operation can be considered equivalent to completing a single internal error-checking operation. Moreover, since the error correction circuit 16 performs the read operation on the memory array based on the internal error-checking command and can only read several bits (e.g., 64 bits, 128 bits, or 256 bits) of stored data from one memory address (internal error-checking address) at a time, it is necessary to count the rows and columns of the memory array for each internal error-checking command to traverse every memory address in the memory array. In this way, each internal error-checking command can correspond to generating one internal error-checking address, thereby ensuring that the stored data in all the memory cells of the memory array undergoes an internal read-modify-write operation. Once all the memory cells in the memory array have undergone a single internal read-modify-write operation, it can be considered that one round of internal error-checking operations has been completed.

As shown in FIG. 1, the clock generation circuit 11 is configured to generate a self-refresh clock signal SR_CLK when the self-refresh enable signal SR_EN indicates that the memory has entered the self-refresh state. Without introducing the internal error-checking function, the internal command generation circuit 12 can generate one self-refresh command signal IREFAB based on each pulse on the self-refresh clock signal SR_CLK to control a single execution of the self-refresh operation. After introducing the internal error-checking function, the clock generation circuit 11 and the internal command generation circuit 12 can be reused, and simple improvements can be made to the internal command generation circuit 12. That is, the internal command generation circuit 12 can receive the error-checking enable signal IMWR_EN. When the error-checking enable signal IMWR_EN is at an active level, it indicates that the internal error-checking function is enabled. The internal command generation circuit 12 needs to periodically "steal" one pulse on the self-refresh clock signal SR_CLK to generate an internal error-checking command signal IMWRAB. That is, whenever the count value of the self-refresh clock signal SR_CLK is a first preset value, the internal command generation circuit generates and outputs one internal error-checking command signal IMWRAB, which is simultaneously sent to the address generation circuit 13 and the control logic circuit 14 to control the execution of the internal read-modify-write operation. In this case, no internal self-refresh command signal IREFAB will be generated based on the "stolen" pulse on the self-refresh clock signal SR_CLK. When the error-checking enable signal IMWR_EN is at an inactive level, it indicates that the internal error-checking function is disabled. The internal command generation circuit 12 generates the internal self-refresh command signal IREFAB based on the self-refresh clock signal SR_CLK to execute the related functions of the original self-refresh operation.

It should be noted that the count value of the self-refresh clock signal SR_CLK refers to the count value generated by counting the pulses on the self-refresh clock signal SR_CLK. Moreover, after generating the internal error-checking command signal IMWRAB, the internal command generation circuit 12 needs to reset the count value of the self-refresh clock signal SR_CLK to zero to ensure that the time interval between generating the internal error-checking command signals IMWRAB remains consistent.

In some embodiments, the first preset value may be any integer greater than one, that is, every time at intervals of the first preset value of pulses, the internal command generation circuit 12 generates one internal error-checking command signal IMWRAB based on the self-refresh clock signal SR_CLK. In other embodiments, the first preset value is set to one, that is, each pulse on the self-refresh clock signal SR_CLK corresponds to the generation of one internal error-checking command signal IMWRAB. In this case, since the internal command generation circuit 12 does not generate the self-refresh command signal IREFAB based on the self-refresh clock signal SR_CLK, to ensure normal execution of the self-refresh operation, it is necessary to execute a single self-refresh operation immediately following the completion of each internal read-modify-write operation.

In the embodiments of the present disclosure, the active level is a high level (logical "1"), and the inactive level is a low level (logical "0"). In other embodiments, the inactive level may also be a high level (logical "1"), and the active level may be a low level (logical "0"), which is not limited in any way.

In some embodiments, the clock generation circuit 11 may be an oscillator with a control terminal. When an external self-refresh entry command (Self-Refresh Entry, SRE) instructs the memory to enter the self-refresh state, the self-refresh enable signal SR_EN will be activated. When the control terminal of the oscillator receives the self-refresh enable signal SR_EN in the active state, the oscillator starts oscillating, generating and outputting the self-refresh clock signal SR_CLK. The period of the self-refresh clock signal can be set based on the interval time of the self-refresh command signal or the self-refresh cycle. Typically, the duty cycle of the self-refresh clock signal SR_CLK is less than 50%. In the embodiments of the present disclosure, the self-refresh enable signal SR_EN is in the active state when it is at a high level (logical "1") and in the deactivated state when it is at a low level (logical "0"). In other embodiments, the self-refresh enable signal SR_EN is in the deactivated state when it is at a high level (logical "1") and in the active state when it is at a low level (logical "0"), which is not limited in any way.

With continued reference to FIG. 1, the address generation circuit 13 is configured to generate a corresponding internal error-checking address IMWR_AD based on the internal error-checking command signal IMWRAB output by the internal command generation circuit 12. The internal error-checking address indicates the target memory cell for executing the current internal error-checking operation (internal read-modify-write operation), allowing the control logic circuit 14 to control the error correction circuit 16 to sequentially perform a single internal read-modify-write operation on the target memory cells in a plurality of memory arrays 15, according to the internal error-checking command signal IMWRAB. The internal error-checking address IMWR_AD includes a target row address and a target column address, and the internal error-checking address IMWR_AD is shared by a plurality of memory arrays 15. That is, the target memory cell indicated by the internal error-checking address IMWR_AD exists in each memory array 15. Moreover, the error correction circuit 16 is shared by the plurality of memory arrays 15, and the error correction circuit 16 can only execute the internal read-modify-write operation on the target memory cell in one memory array 15 at a time. Thus, based on each internal error-checking command signal IMWRAB and the corresponding internal error-checking address IMWR_AD, the error correction circuit 16 needs to sequentially execute a single internal read-modify-write operation on the target memory cell in each memory array 15. That is, the error correction circuit 16 sequentially executes a plurality of internal read-modify-write operations (corresponding to a plurality of sets of internal signals IRD/IWR) to complete the internal error-checking operation (internal read-modify-write operation) corresponding to the current internal error-checking command signal IMWRAB.

In some embodiments, the error correction circuit 16 may be an on-die ECC circuit. The error correction circuit 16 may generate parity data for write data being written into the memory array 15. The error correction circuit may also use the stored data and parity data read from the memory array 15 to detect and correct errors in the stored data. The internal read-modify-write operation in the present disclosure leverages the function of the error correction circuit 16 to check and correct errors in the stored data. In addition, the error correction circuit 16 can use coding methods such as Hamming code, RS code, and convolutional code, which are not specifically limited here.

Furthermore, regarding the composition of the control logic circuit 14, as shown in FIG. 2, the control logic circuit 14 includes a plurality of memory array control circuits 141, and the plurality of memory array control circuits 141 correspond one-to-one with the plurality of memory arrays 15. Each memory array control circuit 141 is configured to: receive the internal error-checking command signal IMWRAB and the internal error-checking address IMWR_AD, sequentially generate a plurality of sets of internal signals IRD/IWR in response to the internal error-checking command signal IMWRAB, and control, when the corresponding memory array 15 is in an enabled state, the error correction circuit 16 to execute a single internal read-modify-write operation on the target memory cell in the corresponding memory array 15 based on a corresponding set of internal signals IRD/IWR. Each set of internal signals includes an internal read signal IRD and an internal write signal IWR.

It should be noted that in a DRAM chip, each memory array 15 may correspond to one memory array control circuit 141. The memory array control circuit 141 can not only control the error correction circuit 16 to perform an internal read-modify-write operation on the corresponding memory array 15 but also control the error correction circuit 16 to execute an external read-modify-write operation on the corresponding memory array 15. That is, the internal error-checking circuit 10 according to the embodiments of the present disclosure enables the original circuits (memory array control circuit 141 and error correction circuit 16) and paths (interaction paths among the memory array control circuit 141, the error correction circuit 16, and the memory array 15) related to external read-modify-write operations and can achieve the execution of the internal read-modify-write operations on the stored data in the memory array 15 by just making simple improvements to the memory array control circuit 141, thereby implementing internal error checking/correction functions.

In addition, the memory array control circuit 141 can also control the corresponding memory array 15 to execute the external read-modify-write operation as well as the normal read/write operation. Specifically, the memory array control circuit 141 can control the corresponding memory cells in the memory array to sequentially execute operations such as word line activation, charge sharing, data amplification, data reading, data writing, and precharging based on information such as the activation command signal, read/write command signal, precharge signal, row address, and column address, thereby achieving the correct reading or writing of stored data.

Exemplarily, if four memory arrays 15 (BA0, BA1, BA2, BA3) share one error correction circuit 16, the logic control circuit 14 includes four memory array control circuits 141 (BA Logic0, BA Logic1, BA Logic2, BA Logic3), corresponding one-to-one with the four memory arrays 15. Each memory array control circuit 141 generates four sets of internal signals IRD/IWR (IRD0/IWR0, IRD1/IWR1, IRD2/IWR2, IRD3/IWR3) to sequentially enable the four memory arrays BA0, BA1, BA2, and BA3, ensuring that the error correction circuit 16 executes an internal read-modify-write operation on only one memory array 15 at a time. During the first time period T0, each memory array control circuit sends the first set of internal signals IRD0/IWR0. In this case, memory array BA0 is in an enabled state, while the other memory arrays BA1, BA2, and BA3 are not enabled. The error correction circuit 16 only receives the first set of internal signals IRD0/IWR0 sent by the corresponding memory array control circuit BA Logic0, controlling the execution of a single internal read-modify-write operation on the target memory cell in memory array BA0. During the second time period T1, each memory array control circuit sends the second set of internal signals IRD1/IWR1. In this case, memory array BA1 is in an enabled state, while the other memory arrays BA0, BA2, and BA3 are not enabled. The error correction circuit 16 only receives the second set of internal signals IRD1/IWR1 sent by the corresponding memory array control circuit BA Logic1, controlling the execution of a single internal read-modify-write operation on the target memory cell in memory array BA1. Similarly, during the third time period T2, the error correction circuit 16 only receives the third set of internal signals IRD2/IWR2 sent by the corresponding memory array control circuit BA Logic2, controlling the execution of a single internal read-modify-write operation on the target memory cell in memory array BA2. During the fourth time period T3, the error correction circuit 16 only receives the fourth set of internal signals IRD3/IWR3 sent by the corresponding memory array control circuit BA Logic3, controlling the execution of a single internal read-modify-write operation on the target memory cell in memory array BA3. Up to this point, based on one set of internal signals sent by the corresponding memory array control circuit, the error correction circuit 16 sequentially executes a single internal read-modify-write operation on the target memory cells in the four memory arrays BA0, BA1, BA2, and BA3.

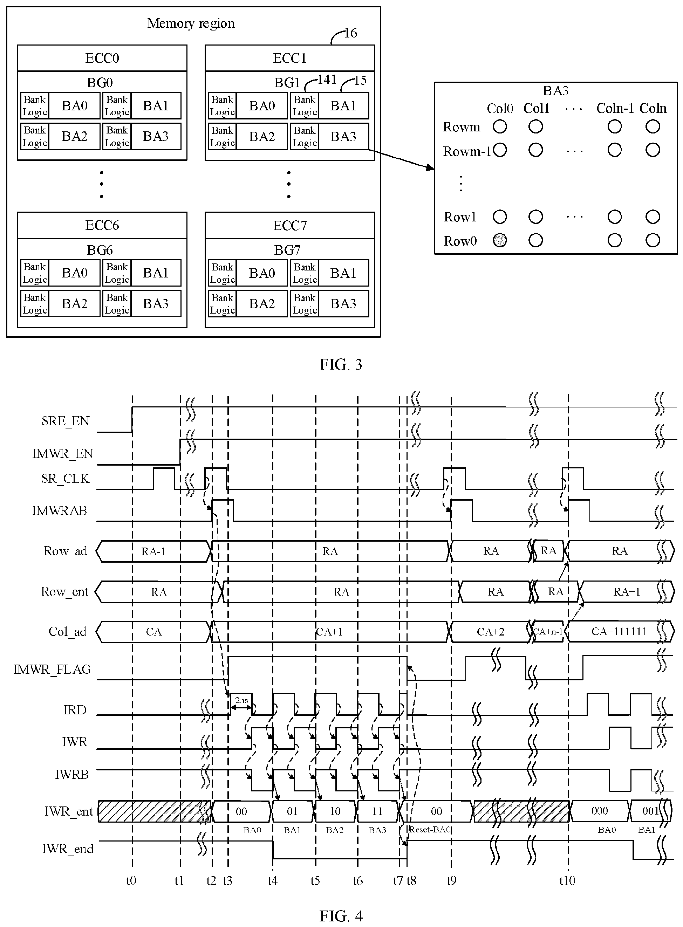

Referring to FIG. 3, FIG. 3 illustrates a schematic layout diagram of a memory array 15, a memory array control circuit 141, and an error correction circuit 16 according to an embodiment of the present disclosure. In the example shown in FIG. 3, the memory region (Array region, also referred to as the Core region) includes eight memory groups (Bank Groups, BG): BG0 to BG7. Different memory groups can operate simultaneously. Each memory group corresponds to one error correction circuit 16: ECC0 to ECC7. Each memory group includes four memory arrays 15 (also referred to as memory banks, BA): BA0, BA1, BA2, and BA3. The four memory arrays BA0, BA1, BA2, and BA3 in each memory group share one error correction circuit 16, and each memory bank in each memory group corresponds to one memory array control circuit 151 (also referred to as a memory bank logic circuit or Bank Logic). Taking BA3 in BG1 as an example, the memory array BA3 includes m rows (Row): ROW0 to ROWm; the memory array BA3 includes n columns (Column, Col): Col0 to Coln. In FIG. 3, one circle represents a plurality of memory cells corresponding to one memory address. Specifically, in the memory array BA3, one memory address (including row address ROW0 and column address Col0) can locate a plurality of corresponding memory cells. Each internal read-modify-write operation is directed at the plurality of memory cells corresponding to one memory address in the memory array 15.

In some embodiments, the internal command generation circuit 12 and the address generation circuit 13 are shared by all the memory arrays 15 within the memory. That is, the internal error-checking command signal IMWRAB generated by the internal command generation circuit 12 and the internal error-checking address IMWR_AD (including the target row address Row_ad and the target column address Col_ad) generated by the address generation circuit 13 are transmitted to each memory array 15, respectively. Since different memory groups BG0 to BG7 can operate simultaneously, each memory group BG needs to be correspondingly provided with one control logic circuit 14 and one error correction circuit 16, and the plurality of memory arrays 15 in each memory group BG can share one control logic circuit 14 and one error correction circuit 16. Specifically, as shown in FIG. 3, the memory region includes a total of 4*8 = 32 memory arrays 15, and the 32 memory arrays 15 within the eight memory groups share one internal command generation circuit 12 and one address generation circuit 13. Each memory group BG corresponds to one control logic circuit 14 (including four memory array control circuits 141) and one error correction circuit 16. The eight memory groups correspond to eight control logic circuits 14 (32 memory array control circuits) and eight error correction circuits 16. The four memory arrays 15 in each memory group BG share one error correction circuit 16, and each memory array control circuit 141 correspondingly controls one memory array.

It should be noted that the memory array may be a memory bank BA, a memory group BG, or a memory block Block. Here, the example where the memory array is a memory bank BA is used for explanation, but this does not constitute a limitation on the present disclosure.

In some embodiments, as shown in FIGS. 1 to 2, the error correction circuit 16 is configured to: read stored data RD_Data from the target memory cell based on the internal read signal IRD and perform error checking and correction on the stored data RD_Data to generate corrected data WR_Data. The error correction circuit 16 is further configured to: write the corrected data WR_Data into the target memory cell based on the internal write signal IWR.

It should be noted that, as shown in FIG. 2, the error correction circuit 16 needs to sequentially execute a single internal read-modify-write operation on a plurality of memory arrays 15 based on a plurality of sets of internal signals IRD/IWR. The error correction circuit 16, when executing the internal read-modify-write operation on each memory array 15, needs to execute the aforementioned read-modify function (i.e., reading stored data RD_Data from the target memory cell based on the internal read signal IRD and performing error checking and correction on the stored data RD_Data to generate corrected data WR_Data) and write function (i.e., writing the corrected data WR_Data into the target memory cell based on the internal write signal IWR).

In some embodiments, as shown in FIG. 1, the internal command generation circuit 12 is further configured to: generate and output, when the error-checking enable signal IMWR_EN indicates that the internal error-checking function is disabled, one internal self-refresh command signal IMWRAB in response to each pulse on the self-refresh clock signal SR_CLK; and generate and output one internal self-refresh command signal IMWRAB when the error-checking enable signal IMWR_EN indicates that the internal error-checking function is enabled and the count value of the self-refresh clock signal SR_CLK is not the first preset value.

It should be noted that, as described above, when the error-checking enable signal IMWR_EN is at an active level, it indicates that the internal error-checking function is enabled, and the internal command generation circuit 12 needs to periodically "steal" one pulse on the self-refresh clock signal SR_CLK to generate the internal error-checking command signal IMWRAB. Conversely, when the count value of the self-refresh clock signal SR_CLK is not the first preset value, or when the error-checking enable signal IMWR_EN is at an inactive level, which indicates that the internal error-checking function is disabled, it is unnecessary to "steal" one pulse on the self-refresh clock signal SR_CLK to generate the internal error-checking command signal IMWRAB. The internal command generation circuit 12 continues to generate and output one internal self-refresh command signal IREFAB based on the pulses on the self-refresh clock signal SR_CLK and performs the related functions of the original self-refresh operation.

With reference to the signal timing diagram shown in FIG. 4, the working principles of the internal error-checking circuit 10 provided by the embodiments of the present disclosure are explained specifically as follows.

At time t0, when the external self-refresh entry command SRE indicates that the memory has entered the self-refresh state, the self-refresh enable signal SR_EN will be activated, i.e., the self-refresh enable signal SR_EN is flipped from a low level to a high level. The clock generation circuit 11 responds to the self-refresh enable signal SR_EN and begins generating and outputting the self-refresh clock signal SR_CLK.

During the t0-t1 phase, the error-checking enable signal IMWR_EN is at an inactive level (low level). In this case, the internal error-checking function is disabled. The internal command generation circuit 12 generates the internal self-refresh command signal IREFAB based on the self-refresh clock signal SR_CLK, thereby controlling the memory array 15 to execute the original self-refresh operation.

At time t1, the error-checking enable signal IMWR_EN flips to an active level (high level). In this case, the internal error-checking function is enabled. The internal command generation circuit 12 begins counting the pulses on the self-refresh clock signal SR_CLK.

At time t2, when the count value of the pulses on the self-refresh clock signal SR_CLK reaches the first preset value for the first time, the first internal error-checking command signal IMWRAB is generated, and the count value is reset.

During the t2-t3 phase, the address generation circuit 13 performs row/column address counting for the memory array based on the received first internal error-checking command signal IMWRAB, and the address generation circuit generates and outputs the target row address Row_ad = RA and the target column address Col_ad = CA+1 = 000000 (the example where the column address is a 6-bit signal and the initial value of the column address CA is 111111 is used for explanation), i.e., the internal error-checking address IMWR_AD. The control logic circuit 14 (or the memory array control circuit 141) sets the operation flag signal IMWR_FLAG to an active level (high level) at time t3 according to the received internal error-checking command signal IMWRAB. Here, the internal error-checking command signal IMWRAB actually refers to the pulse on the internal error-checking command signal.

It should be noted that in the timing diagram shown in FIG. 4, transmission delays between circuits and inherent delays of circuit components have been taken into account. As a result, the timing of changes in some associated signals is not perfectly aligned. Specifically, the internal error-checking command signal IMWRAB is generated at time t2, while the associated operation flag signal IMWR_FLAG flips from an inactive level to an active level at time t3, after time t2.

During the t3-t7 phase, the operation flag signal IMWR_FLAG remains at an active level. The control logic circuit 14 (or memory array control circuit 141) sequentially generates four sets of internal signals, i.e., alternately generates four internal read signals IRD and four internal write signals IWR, to control the error correction circuit 16 to sequentially execute a single internal read-modify-write operation on each of the four memory arrays 15. Here, the example where four memory arrays 15 (BA0 to BA3) share one error correction circuit 16 is used for explanation, which does not constitute a limitation.

Specifically, during the t3-t4 phase, the count value IWR_cnt of the internal write signal is the initial value of 00. In this case, the memory array BA0 is in an enabled state, while memory arrays BA1 to BA3 are not enabled. The error correction circuit 16 receives the first set of internal signals sent by the control logic circuit 14 (or only the corresponding memory array control circuit 141), i.e., the internal read signal IRD and the internal write signal IWR sent during the t3-t4 phase. Based on this first set of internal signals, the error correction circuit 16 executes a signal internal read-modify-write operation on the memory array BA0. At time t4, based on the first rising edge of the inversion signal of the internal write signal IWRB, the count value IWR_cnt of the internal write signal changes from 00 to 01. In this case, the memory array BA1 switches to the enabled state, while other memory arrays remain disabled. During the t4-t5 phase, the error correction circuit 16 receives the second set of internal signals sent by the control logic circuit 14 (or only the corresponding memory array control circuit 141). Based on this second set of internal signals, the error correction circuit 16 executes a signal internal read-modify-write operation on the memory array BA1. Similarly, during the t5-t6 phase, the error correction circuit 16 executes a signal internal read-modify-write operation on the memory array BA2 based on the third set of internal signals. During the t6-t7 phase, the error correction circuit 16 executes a signal internal read-modify-write operation on the memory array BA3 based on the fourth set of internal signals.

Until time t8, based on the final rising edge of the inversion signal of the internal write signal IWRB, the count value IWR_cnt of the internal write signal changes from 11 to 00. The operation end signal IMWR_END generates a rising edge, i.e., flipping from an inactive level (low level, logic "0") to an active level (high level, logic "1"). Based on the rising edge of the operation end signal IMWR_END, the operation flag signal IMWR_FLAG flips from an active level to an inactive level. Up to this point, the current internal read-modify-write operation is fully completed.

At time t9, when the count value of the pulses on the self-refresh clock signal SR_CLK again reaches the first preset value, the second internal error-checking command signal IMWRAB is generated, and the count value is reset. The address generation circuit 13 performs row/column address counting for the memory array based on the second internal error-checking command signal IMWRAB. Specifically, "+1" is applied to the column address, generating and outputting the target column address Col_ad = CA+2 = 000001, while the target row address Row_ad = RA remains unchanged.

Until time t10, when the count value of the pulses on the self-refresh clock signal SR_CLK reaches the first preset value for the n-th time, the n-th internal error-checking command signal IMWRAB is generated. Assuming that n is 64, the address generation circuit 13 executes the 64th "+1" operation on the column address, generating and outputting the target column address Col_ad = 111111, while the target row address Row_ad = RA remains unchanged. In this case, it indicates that the address generation circuit 13 has traversed all column addresses in the RA-th row of the memory array 15 (Col_ad = 000000 to Col_ad = 111111). The error correction circuit 16 will execute the internal read-modify-write operation on the memory cell corresponding to the last column address CA = 111111 of the RA-th row.

It should be noted that the address generation circuit 13 needs to each time synchronously sample and output the target row address Row_ad and the target column address Col_ad based on the internal error-checking command signal IMWRAB. The row count value Row_cnt will change based on the currently generated target column address Col_ad. That is, the target row address Row_ad output through sampling by the address generation circuit 13 each time corresponds to the preceding target column address Col_ad. Moreover, since the next internal error-checking command signal IMWRAB will instruct the error correction circuit 16 to execute an internal read-modify-write operation on the memory cell corresponding to the first column address Col_ad = 000000 in the next row RA+1 of the memory array 15, the row count value Row_cnt needs to be set to RA+1 when the currently generated target column address Col_ad is equal to 111111, such that upon receiving the next internal error-checking command signal IMWRAB, the address generation circuit 13 can synchronously sample and output the correct target row address Row_ad = RA+1 and target column address Col_ad = 000000.

In some embodiments, as shown in FIG. 1, the control logic circuit 14 is further configured to: control the execution of a single self-refresh operation on all the memory arrays 15 after controlling the error correction circuit 16 to sequentially execute a single internal read-modify-write operation on the target memory cells corresponding to the internal error-checking address IMWR_AD in the plurality of memory arrays 15.

It should be noted that when the error-checking enable signal IMWR_EN indicates that the internal error-checking function is enabled, the internal command generation circuit 12 needs to periodically "steal" one pulse on the self-refresh clock signal SR_CLK to generate the internal error-checking command signal IMWRAB. In this case, the "stolen" pulse of the self-refresh clock signal SR_CLK is no longer used to generate the internal self-refresh command signal IREFAB, and in this case, the control logic circuit 14 can no longer execute the self-refresh operation based on the internal self-refresh command signal IREFAB, which is equivalent to skipping one self-refresh operation. To ensure that the original self-refresh function is not affected after the internal error-checking function is introduced, each time after the control logic circuit 14 controls and completes the execution of the internal read-modify-write operation based on the internal error-checking command signal IMWRAB, a single self-refresh operation can be immediately executed on all the memory arrays 15 (without waiting for the next pulse of the self-refresh clock signal SR_CLK), which effectively compensates for the impact on the original self-refresh function due to the execution of the internal error-checking operation.

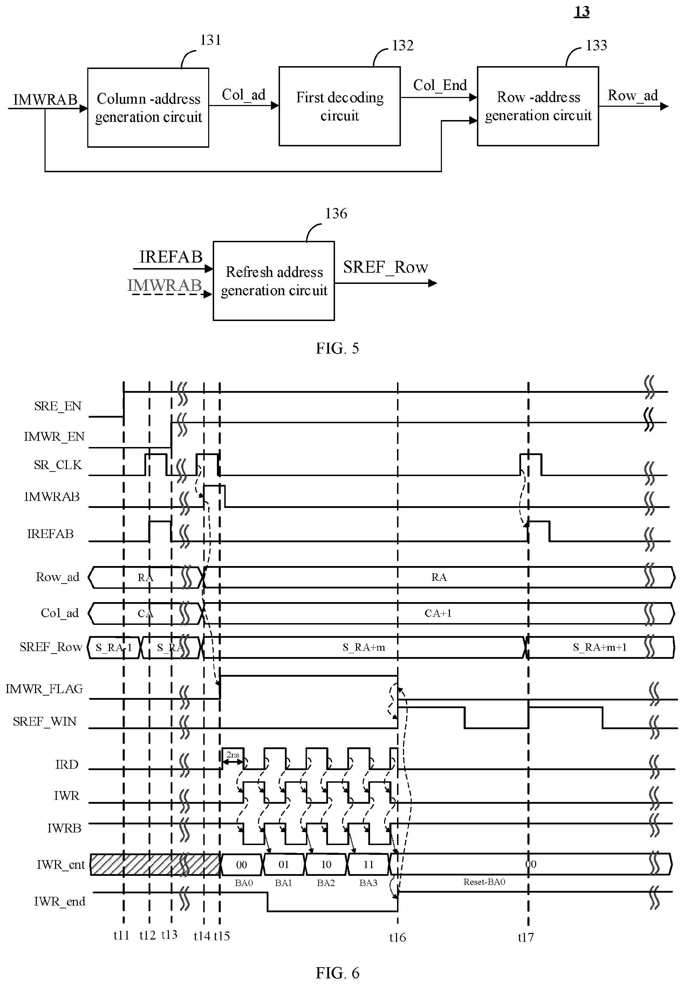

In some embodiments, as shown in FIG. 5, an address generation circuit 13 includes a column-address generation circuit 131, a first decoding circuit 132, and a row-address generation circuit 133.

The column-address generation circuit 131 is configured to receive an internal error-checking command signal IMWRAB, perform column counting on the current memory row based on the internal error-checking command signal IMWRAB, and generate and output a target column address Col_ad.

The first decoding circuit 132 is configured to decode the target column address Col_ad and generate and output a column end signal Col_End when the target column address Col_ad indicates that column counting for the current memory row is complete.

The row-address generation circuit 133 is configured to receive the column end signal Col_End and the internal error-checking command signal IMWRAB and perform row counting on the memory array based on the column end signal Col_End to generate and output a target row address signal Row_ad.

Taking the memory region shown in FIG. 3 as an example, the working principle of the address generation circuit 13 will be explained with reference to FIGS. 4 and 5. The column-address generation circuit 131 can sequentially traverse all the column addresses (Col_ad=000000 to Col_ad=111111) of each row in the memory array 15. Each time, the column-address generation circuit performs a "+1" count on the current column address based on the internal error-checking command signal IMWRAB to generate and output the target column address Col_ad, until the currently generated target row address Row_ad = RA and the target column address Col_ad = 111111, as shown at time t10 in FIG. 4, which indicates that the column-address generation circuit 131 has completed the traversal counting on all the column addresses (Col_ad=000000 to Col_ad=111111) of the current row RA in the memory array 15. In this case, the first decoding circuit 132 decodes the current target column address Col_ad=111111 and outputs the column end signal Col_End to instruct the row-address generation circuit 133 to perform a "+1" count on the current row address to generate and output a new target row address RA+1. Meanwhile, the column-address generation circuit 131 will still perform a "+1" count on the target column address Col_ad=111111 next time, obtaining a new target column address Col_ad=000000. This indicates the execution of the internal read-modify-write operation on the memory cell corresponding to the first column address of the next row RA+1.

With reference to FIGS. 1, 5, and 6, the working principle of the internal error-checking circuit 10 in the embodiments of the present disclosure, which continues to execute a single self-refresh operation after controlling the execution of the internal read-modify-write operation, is explained specifically as follows.

At time t11, similar to FIG. 4, when the external self-refresh entry command SRE indicates that the memory has entered the self-refresh state, the self-refresh enable signal SR_EN is activated, and the clock generation circuit 11 begins generating and outputting the self-refresh clock signal SR_CLK.

During the t11-t13 phase, the error-checking enable signal IMWR_EN is at an inactive level. In this case, the internal error-checking function is disabled. The internal command generation circuit 12 generates one internal self-refresh command signal IREFAB based on each pulse on the self-refresh clock signal SR_CLK to control the memory array 15 to execute a single self-refresh operation. Specifically, at time t13, the internal command generation circuit 12 generates one internal self-refresh command signal IREFAB based on the self-refresh clock signal SR_CLK. Meanwhile, the address generation circuit 13 (or the refresh-address generation circuit 136) also performs row counting on the memory array based on the internal self-refresh command signal IREFAB and generates and outputs a self-refresh address S_RA. The control logic circuit 14 (or the memory array control circuit 141) controls the self-refresh operation on the memory rows corresponding to the self-refresh address S_RA in all the memory arrays 15.

At time t13, the error-checking enable signal IMWR_EN flips to an active level. In this case, the internal error-checking function is enabled. The internal command generation circuit 12 begins counting the pulses on the self-refresh clock signal SR_CLK.

During the t14-t16 phase, when the count value of the pulses on the self-refresh clock signal SR_CLK reaches the first preset value for the first time (taking the first preset value being m as an example for explanation), the internal command generation circuit 12 generates the internal error-checking command signal IMWRAB, and then the address generation circuit 13 and the control logic circuit 14 (or the memory array control circuit 141) control the error correction circuit 16 to sequentially execute a single internal read-modify-write operation on a plurality of memory arrays 15. The timing sequence for this operation is the same as that shown in FIG. 4. Reference can be made to the above descriptions for details, which will not be repeated here.

It should be noted that during the t13-t14 phase, before the internal read-modify-write operation is executed (that is, before the count value of the pulses on the self-refresh clock signal SR_CLK reaches the first preset value m for the first time), the internal command generation circuit 12 has generated m-1 self-refresh command signals IREFAB. Accordingly, the address generation circuit 13 (or the refresh-address generation circuit 136) also performs m-1 "+1" counts on the self-refresh address SREF_Row based on the m-1 self-refresh command signals IREFAB, and the self-refresh address SREF_Row changes to S_RA+m-1. After completing the execution of the internal read-modify-write operation and continuing to execute a single self-refresh operation, to prevent the current self-refresh operation from being repeatedly executed on the previous self-refresh address S_RA+m-1, the address generation circuit 13 (or the refresh-address generation circuit 136) also needs to perform a "+1" count on the self-refresh address SREF_Row to output the self-refresh address SREF_Row corresponding to the self-refresh operation. However, because the internal command generation circuit 12 does not generate the self-refresh command signal IREFAB, at time t14, the address generation circuit 13 (or the refresh-address generation circuit 136) can perform a "+1" count on the self-refresh address SREF_Row based on the internal error-checking command signal IMWRAB to output a new self-refresh address SREF_Row = S_RA+m.

At time t16, the operation flag signal IMWR_FLAG flips from an active level to an inactive level, which indicates that all the memory arrays 15 complete the current internal read-modify-write operation. In this case, in response to the falling edge of the operation flag signal IMWR_FLAG, the control logic circuit 14 (which may specifically be the self-refresh control circuit 147 in the memory array control circuit 141) flips a self-refresh window signal SREF_WIN from an inactive level (low level, logic "0") to an active level (high level, logic "1"). Based on the self-refresh window signal SREF_WIN at an active level and the received self-refresh address S_RA+m, the control logic circuit 14 (which may specifically be the self-refresh control circuit 147 in the memory array control circuit 141) controls the memory array 15 to execute a single self-refresh operation.

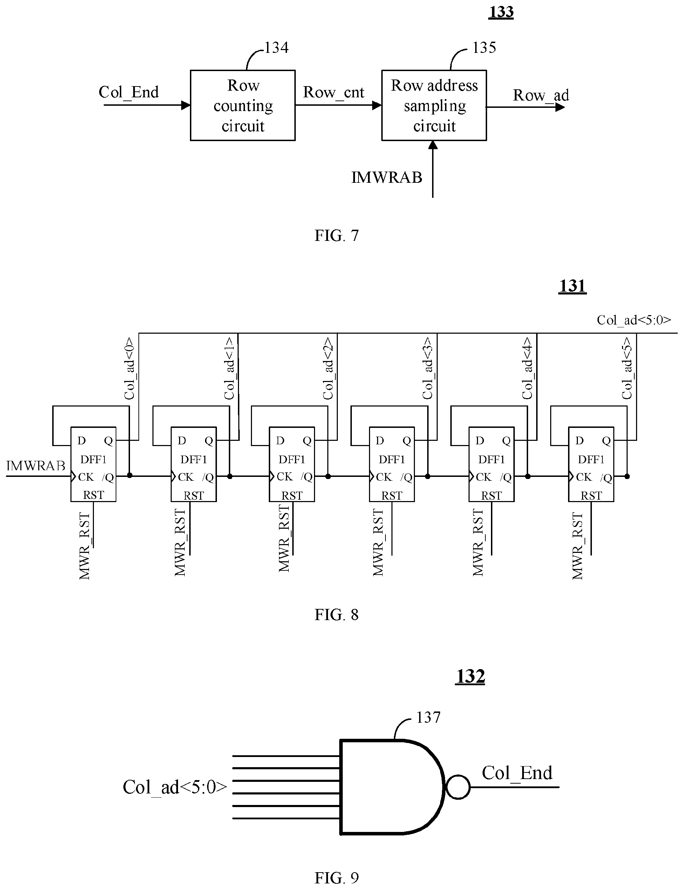

In some embodiments, as shown in FIG. 7, the row-address generation circuit 133 includes: a row counting circuit 134, configured to receive the column end signal Col_End and perform row counting on the memory array 15 based on the column end signal Col_End, generating and outputting a row count value Row_cnt; a row-address sampling circuit 135, configured to receive the internal error-checking command signal IMWRAB and the row count value Row_cnt and sample the row count value Row_cnt in response to the internal error-checking command signal IMWRAB, generating and outputting a target row address signal Row_ad.

It should be noted that after the control logic circuit 14 (or the memory array control circuit 141) receives the internal error-checking command signal IMWRAB, it is also necessary to wait for the corresponding internal error-checking address (that is, the target row address Row_ad and the target column address Col_ad) before the error correction circuit 16 can be controlled to execute the internal read-modify-write operation. In order not to influence the timing requirements of the original external read-modify-write operation of the memory, the column-address generation circuit 131 and the row-address generation circuit 133 need to each time synchronously sample and output the target row address Row_ad and the target column address Col_ad based on the internal error-checking command signal IMWRAB, which can ensure that the output time of the target row address Row_ad and the target column address Col_ad is less delayed compared with the internal error-checking command signal IMWRAB.

It should also be noted that the row counting circuit 134 performs row counting on the column end signal Col_End to generate the row count value Row_cnt. The row count value Row_cnt changes based on the currently generated target column address Col_ad, and the target column address Col_ad changes based on the internal error-checking command signal IMWRAB. Therefore, before the row count value Row_cnt changes, the row-address sampling circuit 135 has completed sampling on the row count value Row_cnt based on the internal error-checking command signal IMWRAB and outputs the target row address Row_ad, that is, the target row address Row_ad sampled and outputted by the row-address sampling circuit 135 each time corresponds to the preceding target column address Col_ad output by the row-address generation circuit 131.

In some embodiments, as shown in FIG. 5, the address generation circuit 13 further includes a refresh-address generation circuit 136, which is configured to receive the internal self-refresh command signal IREFAB and perform row counting on the memory array 15 based on the internal self-refresh command signal IREFAB to generate and output a self-refresh address SREF_Row. The control logic circuit 14 is further configured to: control the execution of a single refresh operation on all the memory arrays based on the self-refresh address SREF_Row.

It should be noted that refresh is executed on one or more rows of the memory array 15. Therefore, the refresh-address generation circuit 136 does not need to perform traversal counting on the column address but only needs to complete traversal counting for the row address. The self-refresh address SREF_Row includes only row address information.

In some embodiments, with continued reference to FIG. 5, the address generation circuit 13 further includes a refresh-address generation circuit 136, which is configured to receive the internal self-refresh command signal IREFAB or the internal error-checking command signal IMWRAB and perform row counting on the memory array 15 based on the internal self-refresh command signal IREFAB or the internal error-checking command signal IMWRAB to generate and output the self-refresh address SREF_Row.

With reference to FIG. 6, at time t16, when the control logic circuit 14 continues to execute a single self-refresh operation after controlling and completing the execution of the internal read-modify-write operation, the refresh-address generation circuit 136 included in the address generation circuit 13 also needs to synchronously output the self-refresh address SREF_Row corresponding to the self-refresh operation to the control logic circuit 14. If the refresh-address generation circuit 136 performs row counting on the memory array only based on the internal self-refresh command signal IREFAB, but the internal self-refresh command signal IREFAB is not generated as the current pulse of the self-refresh clock signal SR_CLK is "stolen" to generate the internal error-checking command signal IMWRAB, then the refresh-address generation circuit 136 cannot perform row counting on the memory array based on the internal self-refresh command signal IREFAB to generate a new self-refresh address, and the refresh-address generation circuit 136 will continue to output the self-refresh address S_RA corresponding to the previous self-refresh operation (the refresh operation before time t10), leading to repeated refreshing of the same row address's memory cell twice. Therefore, in this case, the refresh-address generation circuit 136 can be configured to: receive the internal error-checking command signal IMWRAB and the internal self-refresh command signal IREFAB simultaneously and perform row counting on the memory array based on the internal error-checking command signal IMWRAB or the internal self-refresh command signal IREFAB to generate and output the self-refresh address SREF_Row. That is, regardless of whether the internal command address generation circuit 12 generates the internal error-checking command signal IMWRAB or the internal self-refresh command signal IREFAB, the refresh-address generation circuit 136 can perform a single row counting on the memory array. For example, at time t10, the refresh-address generation circuit 136 can generate a new self-refresh address S_RA+m based on the internal error-checking command signal IMWRAB to ensure that at time t16, after the internal read-modify-write operation, a single self-refresh operation can continue to be executed on the new self-refresh address S_RA+m, thereby avoiding executing two self-refresh operations on the same row address at time t15.

In some embodiments, the memory array control circuit 141 can control the execution of a single refresh operation simultaneously for a plurality of memory rows of the memory array 15. In this case, the refresh-address generation circuit 136 can output a plurality of self-refresh addresses simultaneously. Each time, the refresh-address generation circuit 136 performs row counting on the memory array based on the internal error-checking command signal IMWRAB or the internal self-refresh command signal IREFAB, and the counting might not necessarily be an increment of +1. Exemplarily, based on the parameter configuration in the mode register, the memory array control circuit 141 can simultaneously execute the refresh operation on four memory rows. Each time, the refresh-address generation circuit 136 performs +4 row counting on the memory array based on the internal error-checking command signal IMWRAB or the internal self-refresh command signal IREFAB. If the four self-refresh addresses corresponding to the previous self-refresh operation are S_RA, S_RA+1, S_RA+2, and S_RA+3, the four self-refresh addresses output this time are S_RA+4, S_RA+5, S_RA+6, and S_RA+7. Additionally, if the memory rows of the memory array are divided into four groups, each group with P memory rows, the refresh-address generation circuit 136 can also perform +1 row counting each time. If the four self-refresh addresses corresponding to the previous self-refresh operation are S_RA, S_RA+P, S_RA+2P, and S_RA+3P, the four self-refresh addresses output this time are S_RA+1, S_RA+P+1, S_RA+2P+1, and S_RA+3P+1.

In some embodiments, as shown in FIGS. 8 and 9, a column-address generation circuit 131 includes N cascaded first flip-flops DFF1, where N is an integer greater than or equal to one. The clock control terminal of the first flip-flop DFF1 in the first stage serves as the input terminal of the column-address generation circuit 131 and receives the internal error-checking command signal IMWRAB. The inverted output terminal of the first flip-flops DFF1 in each stage is connected to the data input terminal of the first flip-flops DFF1; the clock control terminals of the other first flip-flops DFF1, except for the first flip-flop DFF1 in the first stage, are all connected to the inverted output terminal of the first flip-flop DFF1 in the preceding stage; the non-inverted output terminals of the N first flip-flops DFF1 collectively output the target column address Col_ad. The first decoding circuit includes a first NAND gate 137, and the N input terminals of the first NAND gate 137 are respectively connected to the non-inverted output terminals of the N first flip-flops DFF1, and the output terminal of the first NAND gate 137 is configured to output the column end signal.

In FIGS. 8 and 9, the example of N = 6 is used for explanation, that is, the target column address Col_ad<5:0> includes 6-bit information. However, this does not constitute a limitation on the present disclosure.

It should be noted that the column-address generation circuit 131 shown in FIG. 8 is a synchronous binary counter. In some other embodiments, the column-address generation circuit 131 may also be implemented by an asynchronous binary counter, which is not specifically limited here. The first decoding circuit 132 shown in FIG. 9 outputs a column count signal Col_End when Col_ad<5:0> is 111111, that is, performing traversal counting on the target column address Col_ad<5:0> according to the order of CA=000000 to CA=111111. In some other embodiments, the traversal counting may also be performed in other orders. Specifically, the traversal counting may be performed on the target column address Col_ad<5:0> in the order of CA=100000 to CA=011111, and in this case, the first decoding circuit 132 outputs the column count signal Col_End when Col_ad<5:0> is 011111.

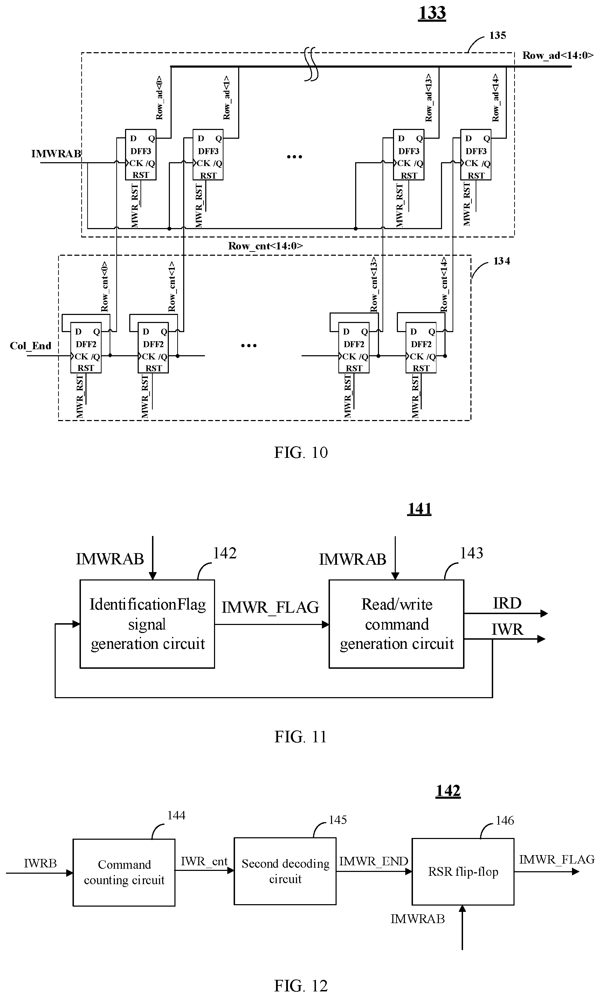

In some embodiments, as shown in FIG. 10, the row counting circuit 134 includes M cascaded second flip-flops DFF2, where M is an integer greater than or equal to one. The clock control terminal of the second flip-flop DFF2 in the first stage serves as the input terminal of the row counting circuit 134 and receives the column end signal Col_End. The inverted output terminal of the second flip-flop DFF2 in each stage is connected to the data input terminal of the second flip-flop DFF2; the clock control terminals of the other second flip-flops DFF2, except for the second flip-flop DFF2 in the first stage, are all connected to the inverted output terminal of the second flip-flop DFF2 in the preceding stage; the non-inverted output terminals of the M second flip-flops DFF2 collectively output the row count value Row_cnt. The row-address sampling circuit 135 includes M third flip-flops DFF3; the clock control terminal of each of the M third flip-flops DFF3 receives the internal error-checking command signal IMWRAB; the data input terminals of the M third flip-flops DFF3 are connected to the non-inverted output terminals of the M second flip-flops DFF2 in a one-to-one correspondence manner to receive the row count value Row_cnt; the non-inverted output terminals of the M third flip-flops DFF3 collectively output the target row address Row_ad.

It should be noted that in FIG. 10, the example of M = 15 is used for explanation, that is, the row count value Row_cnt<14:0> and the target row address Row_ad<14:0> each include 15-bit information. However, this does not constitute a limitation on the present disclosure. The row counting circuit 134 shown in FIG. 10 is a synchronous binary counter. In other embodiments, the row counting circuit 134 may also be implemented using an asynchronous binary counter, which is not specifically limited here.

In some embodiments, as shown in FIG. 11, the memory array control circuit 141 includes: a flag signal generation circuit 142, configured to receive an internal error-checking command signal IMWRAB and generate and output, in response to the internal error-checking command signal IMWRAB, an operation flag signal IMWR_FLAG at an active level; and a read/write command generation circuit 143, configured to receive the operation flag signal IMWR_FLAG and the internal error-checking command signal IMWRAB and sequentially generate, in response to the internal error-checking command signal IMWRAB, a plurality of sets of internal signals during the period when the operation flag signal IMWR_FLAG is at an active level. The flag signal generation circuit 142 is further configured to receive an internal write signal IWR and set the operation flag signal IMWR_FLAG to an inactive level when the count value of the internal write signal IWR reaches a second preset value.

It should be noted that the second preset value is associated with the number of a plurality of memory arrays 15 in each memory group BG that share the error correction circuit 16. This ensures that the plurality of sets of internal signals (internal read signal IRD and internal write signal IWR) generated and output by the read/write command generation circuit 143 can control the error correction circuit 16 to sequentially execute a single internal read-modify-write operation on each of the plurality of memory arrays 15.

In some embodiments, as shown in FIG. 12, the flag signal generation circuit 142 includes: a command counting circuit 144, configured to count the inversion signal of the internal write signal IWR to generate and output the count value of the internal write signal IWR; a second decoding circuit 145, configured to receive the count value of the internal write signal IWR and generate and output an operation end signal IMWR_END when the count value of the internal write signal IWR is a second preset value; and an SR flip-flop 146, configured to receive the internal error-checking command signal IMWRAB and the operation end signal IMWR_END, set, in response to the internal error-checking command signal IMWRAB, the operation flag signal IMWR_FLAG to an active level, and set the operation flag signal IMWR_FLAG to an inactive level when the count value of the internal write signal IWR reaches the second preset value.

Exemplarily, as shown in FIGS. 3 and 4, if each memory group BG includes one error correction circuit 16 and four memory arrays 15 (BA0, BA1, BA2, BA3), the second preset value in this case is 4 (represented in binary as "00"). That is, during the period when the operation flag signal IMWR_FLAG is at the active level, the read/write command generation circuit 143 needs to generate four sets of internal signals. At time t3, the SR flip-flop 146 in the flag signal generation circuit 142 sets the operation flag signal IMWR_FLAG to the active level (high level) based on the received internal error-checking command signal IMWRAB. Subsequently, during the period when the operation flag signal IMWR_FLAG is at the active level, i.e., the t3-t7 phase, four internal read signals IRD and four internal write signals IWR are alternately generated, which are respectively recorded as follows: a set of internal signals IRD1 and IWR1 corresponding to BA0 (during the t3-t4 phase), a set of internal signals IRD2 and IWR2 corresponding to BA1 (during the t4-t5 phase), a set of internal signals IRD3 and IWR3 corresponding to BA2 (during the t5-t6 phase), and a set of internal signals IRD4 and IWR4 corresponding to BA3 (during the t6-t7 phase). Each set of internal signals is used to control the error correction circuit 16 to sequentially execute a single internal read-modify-write operation on the stored data corresponding to the internal error-checking address in the four memory arrays 15. Moreover, each internal read-modify-write operation first involves reading the stored data RD_Data and performing error checking and correction based on the internal read signal IRD, and then writing the corrected data WR_Data, after error checking and correction, into the memory array based on the internal write signal IWR. To ensure that all memory arrays successfully complete the internal read-modify-write operations, the command counting circuit 144 needs to be used to count either the internal write signal IWR or the inversion signal of the internal write signal IWRB. At time t7, counting is performed based on the last rising edge of the inversion signal of the internal write signal IWRB, and when the count value IWR_cnt of the internal write signal output by the command counting circuit 144 is the second preset value of 4 (represented in binary as "00"), the error correction circuit 16 has already written the corresponding corrected data into the corresponding memory array BA3 based on the last internal write signal IWR4. The second decoding circuit 145 will output IMWR_END to indicate that all the memory arrays 15 have completed the internal read-modify-write operations. At this point, the operation flag signal IMWR_FLAG can be set to an inactive level to stop the further generation of internal signals IRD/IWR.

It should be noted that to ensure the proper completion of the final write operation executed by the error correction circuit 16 based on the internal write signal IWR4, the inversion signal of the internal write signal IWRB can be counted to generate the count value IWR_cnt of the internal write signal. This solution ensures that when the count value of the internal write signal reaches the second preset value of 4 (i.e., at time t7 in FIG. 4, where the fourth rising edge of IWRB corresponds to the fourth falling edge of IWR), the error correction circuit 16 has already completed the final write operation based on the internal write signal IWR (at the active level, high level "1"). In this case, even if the operation flag signal IMWR_FLAG is set to an inactive level so that the read/write command generation circuit 143 is no longer generating internal signals IRD/IWR, this will not affect the execution of the final internal read-modify-write operation by the error correction circuit 16.

It should also be noted that the count value IWR_cnt of the internal write signal shown in FIG. 4 is represented by a 2-bit signal, and the second preset value of 4 corresponds to the signal "00", which happens to be the initial value of the count value IWR_cnt of the internal write signal. Therefore, after the operation flag signal IMWR_FLAG is set to the inactive level, there is no need to reset the count value IWR_cnt of the internal write signal. However, in some other embodiments, the count value IWR_cnt of the internal write signal is represented by a 3-bit signal, and the second preset value of 4 corresponds to the signal "100". In this case, after the operation flag signal IMWR_FLAG is set to the inactive level, it is necessary to reset the count value IWR_cnt of the internal write signal to the initial value of "000".

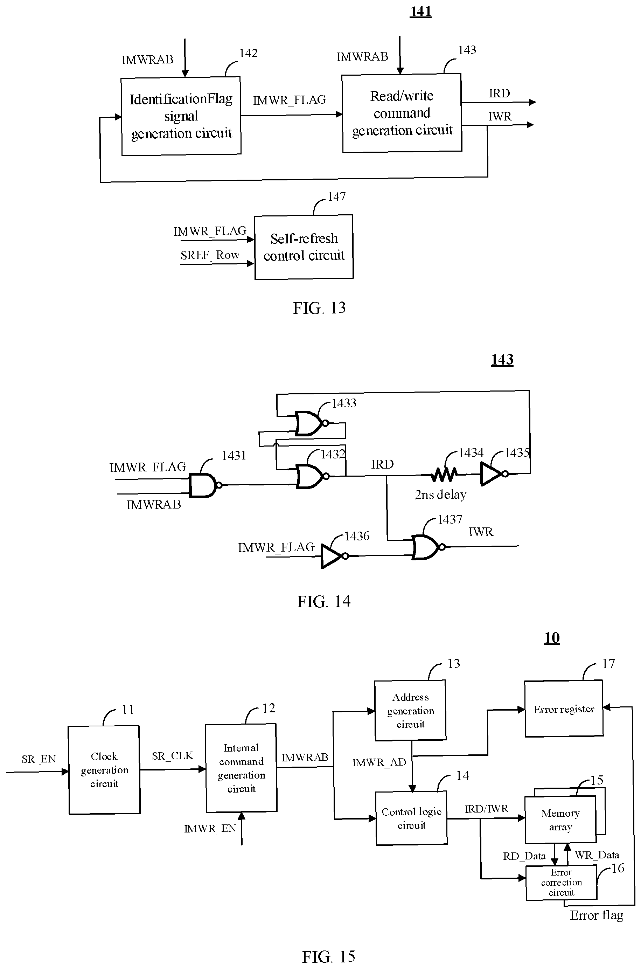

In some embodiments, as shown in FIG. 14, the read/write command generation circuit 143 includes: a second NAND gate 1431, a first NOR gate 1432, a second NOR gate 1433, a delay unit 1434, a first NOT gate 1435, a second NOT gate 1436, and a third NOR gate 1437. The first input terminal of the second NAND gate 1431 receives the operation flag signal IMWR_FLAG, and the second input terminal of the second NAND gate 1431 receives the internal error-checking command signal IMWRAB. The first input terminal of the first NOR gate 1432 is electrically connected to the output terminal of the second NAND gate 1431, and the output terminal of the first NOR gate 1432 is configured to output the internal read signal IRD. The first input terminal of the second NOR gate 1433 is electrically connected to the output terminal of the first NOR gate 1432, and the output terminal of the second NOR gate 1433 is electrically connected to the second input terminal of the first NOR gate 1432. The input terminal of the delay unit 1434 is electrically connected to the output terminal of the first NOR gate 1432. The input terminal of the first NOT gate 1435 is electrically connected to the output terminal of the delay unit 1434, and the output terminal of the first NOT gate 1435 is electrically connected to the second input terminal of the second NOR gate 1433. The input terminal of the second NOT gate 1436 receives the operation flag signal IMWR_FLAG. The first input terminal of the third NOR gate 1437 is electrically connected to the output terminal of the second NOT gate 1436, the second input terminal of the third NOR gate 1437 is electrically connected to the output terminal of the first NOR gate 1432, and the output terminal of the third NOR gate 1437 is configured to output the internal write signal IWR.

It should be noted that the delay time of the delay unit 1434 for the input signal is equal to the pulse width of the internal read signal IRD and the internal write signal IWR. Here, the example where the delay time, the pulse width of the internal write signal IWR, and the pulse width of the internal read signal IRD are all 2 ns is used for explanation. In some embodiments, the delay time of the delay unit 1434 may also be adjustable. Specifically, the delay time of the delay unit 1434 may be adjusted based on the timing requirements of the internal read-modify-write operation. That is, it is ensured that, during the pulse width time of the internal read signal IRD, the error correction circuit 16 can complete the reading, error checking, and error correction operations on the stored data of the target memory cell in the memory array 15. Additionally, it is ensured that, during the pulse width time of the internal write signal IWR, the error correction circuit 16 can write the corrected data, after error checking and correction, into the target memory cell in the memory array 15. In some embodiments, the pulse width of the internal write signal IWR and the pulse width of the internal read signal IRD may also be different, which is not limited here.

In some embodiments, as shown in FIG. 13, the memory array control circuit 141 further includes: a self-refresh control circuit 147, configured to receive an operation flag signal IMWR_FLAG and a self-refresh address SREF_Row and control, when the operation flag signal IMWR_FLAG flips to an inactive level, the corresponding memory array 15 to execute a single refresh operation based on the self-refresh address SREF_Row.

In some embodiments, as shown in FIG. 15, the error correction circuit 16 is further configured to: generate and output, when executing an internal read-modify-write operation on a target memory cell, an error flag signal Error flag if there is an error in the stored data RD_Data in the target memory cell. The internal error-checking circuit 10 further includes: an error register 17, configured to receive the internal error-checking address IMWR_AD and the error flag signal Error flag and store, in response to the error flag signal Error flag, the internal error-checking address IMWR_AD.

It should be noted that the error register 17 may be a mode register reserved within the memory. The mode register stores the internal error-checking address IMWR_AD based on the error flag signal Error flag. Various repair operations can be executed internally within the memory based on the stored error information. Alternatively, the stored error information may be periodically provided to the memory controller, which may perform redundancy repair processing based on the error signal or skip the memory address where the data error occurred during the next execution of the read/write operation, so as to protect data accuracy and enhance the stability of the memory system.

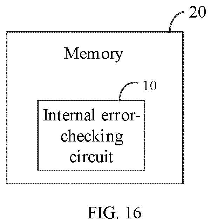

In still another embodiment of the present disclosure, referring to FIG. 16, a schematic diagram of the composition structure of a memory 20 according to an embodiment of the present disclosure is illustrated. As shown in FIG. 16, the memory 20 may include the internal error-checking circuit 10 according to any one of the foregoing embodiments.

In some embodiments, the memory 20 may include DRAM.

It should be noted that the embodiments of the present disclosure introduce an internal error-checking circuit design into DRAM LPDDR series chips and DRAM DDR4 chips, thereby implementing a new function similar to the ECS operation in DDR5. Moreover, the internal error-checking circuit 10 reuses the original clock generation circuit for self-refresh operations, as well as the operational circuits and paths for executing external read-modify-write commands. This does not impact the timing of the original self-refresh operations or external read-modify-write operations. Furthermore, only simple improvements to the original internal command generation circuit, address generation circuit, and control logic circuit are needed to enable periodic data error checking/correction operations for a plurality of memory arrays. While implementing the internal error-checking mechanism to effectively improve the stability of stored data, the circuit design is optimized to save circuit area on the DRAM chip.

In the embodiments of the present disclosure, DRAM can conform not only to memory specifications such as DDR, DDR2, DDR3, DDR4, DDR5, and DDR6 but also to LPDDR, LPDDR2, LPDDR3, LPDDR4, LPDDR5, and LPDDR6, among others, which is not limited in any way.

In the embodiments of the present disclosure, since the memory 20 includes the internal error-checking circuit 10 according to any one of the foregoing embodiments, the internal error-checking operations for the memory can be achieved, thereby improving the performance of the memory.

The above descriptions are merely exemplary embodiments of the present disclosure and are not intended to limit the protection scope of the present disclosure.

It should be noted that in the present disclosure, the terms "include", "comprise", or any other variants thereof are intended to cover non-exclusive inclusion, such that a process, a method, an item, or an apparatus including a series of elements includes not only those elements but also other elements not explicitly listed, or elements inherent to such process, method, item, or apparatus. Without further limitation, an element defined by the phrase "including a..." does not exclude the presence of additional identical elements in the process, method, item, or apparatus that includes the element.

The serial numbers of the embodiments of the present disclosure described above are for the purpose of describing only and do not represent the superiority or inferiority of the embodiments.

The features disclosed in the product embodiments provided in the present disclosure may be combined in any manner without conflict to obtain new product embodiments.

The above description is only the specific embodiments of the present disclosure, but the protection scope of the present disclosure is not limited thereto; changes or substitutions that any of those skilled in the art can easily think of within the technical scope disclosed by the present disclosure shall all fall within the protection scope of the present disclosure. Therefore, the protection scope of the present disclosure shall be subject to the protection scope of the claims.

## Claims

1. An internal error-checking circuit (10), comprising: a clock generation circuit (11), an internal command generation circuit (12), an address generation circuit (13), a control logic circuit (14), and an error correction circuit (16), wherein
the clock generation circuit (11) is configured to: generate and output a self-refresh clock signal (SR_CLK) in response to a self-refresh enable signal (SR_EN);
the internal command generation circuit (12) is configured to: receive the self-refresh clock signal (SR_CLK) and an error-checking enable signal (IMWR_EN), count the self-refresh clock signal (SR_CLK) when the error-checking enable signal (IMWR_EN) indicates that an internal error-checking function is enabled, and generate and output one internal error-checking command signal (IMWRAB) when a count value (IWR_cnt) of the self-refresh clock signal (SR_CLK) is a first preset value;
the address generation circuit (13) is configured to: receive the internal error-checking command signal (IMWRAB) and count the internal error-checking command signal (IMWRAB) to generate and output an internal error-checking address (IMWR_AD); and
the control logic circuit (14) is configured to: receive the internal error-checking command signal (IMWRAB) and the internal error-checking address (IMWR_AD) and control, in response to the internal error-checking command signal (IMWRAB), the error correction circuit (16) to sequentially execute a single internal read-modify-write operation on target memory cells corresponding to the internal error-checking address (IMWR_AD) in a plurality of memory arrays (15),
wherein the plurality of memory arrays (15) share the error correction circuit (16).

2. The internal error-checking circuit (10) according to claim 1, wherein
the control logic circuit (14) comprises a plurality of memory array control circuits (141), and the plurality of memory array control circuits (141) correspond one-to-one with the plurality of memory arrays (15);
each of the plurality of memory array control circuits (141) is configured to: receive the internal error-checking command signal (IMWRAB) and the internal error-checking address (IMWR_AD), sequentially generate a plurality of sets of internal signals (IRD/IWR) in response to the internal error-checking command signal (IMWRAB), and control, when a corresponding memory array (15) is in an enabled state, the error correction circuit (16) to execute a single internal read-modify-write operation on the target memory cell in the corresponding memory array (15) based on a corresponding set of internal signals (IRD/IWR),
wherein each set of the plurality of sets of internal signals (IRD/IWR) comprises an internal read signal (IRD) and an internal write signal (IWR).

3. The internal error-checking circuit (10) according to claim 2, wherein
the error correction circuit (16) is configured to: read stored data from the target memory cell based on the internal read signal (IRD) and perform error checking and correction on the stored data to generate corrected data; and
the error correction circuit (16) is further configured to: write the corrected data into the target memory cell based on the internal write signal (IWR).

4. The internal error-checking circuit (10) according to any one of claims 1 to 3, wherein
the internal command generation circuit (12) is further configured to: generate and output, when the error-checking enable signal (IMWR_EN) indicates that the internal error-checking function is disabled, one internal self-refresh command signal (IREFAB) in response to each pulse on the self-refresh clock signal (SR_CLK); and generate and output one internal self-refresh command signal (IREFAB) when the error-checking enable signal (IMWR_EN) indicates that the internal error-checking function is enabled and the count value (IWR_cnt) of the self-refresh clock signal (SR_CLK) is not the first preset value.

5. The internal error-checking circuit (10) according to any one of claims 1 to 4, wherein
the control logic circuit (14) is further configured to: control the execution of a single self-refresh operation on all the memory arrays (15) after controlling the error correction circuit (16) to sequentially execute a single internal read-modify-write operation on the target memory cells corresponding to the internal error-checking address (IMWR_AD) in the plurality of memory arrays (15).

6. The internal error-checking circuit (10) according to claim 2, wherein the address generation circuit (13) comprises a column-address generation circuit (131), a first decoding circuit (132), and a row-address generation circuit (133), wherein
the column-address generation circuit (131) is configured to: receive the internal error-checking command signal (IMWRAB), perform column counting on a current memory row based on the internal error-checking command signal (IMWRAB), and generate and output a target column address (Col_ad);
the first decoding circuit (132) is configured to: decode the target column address (Col_ad) and generate and output a column end signal (Col_End) when the target column address (Col_ad) indicates that column counting for the current memory row is complete; and
the row-address generation circuit (133) is configured to: receive the column end signal (Col_End) and the internal error-checking command signal (IMWRAB) and perform row counting on the memory array (15) based on the column end signal (Col_End) to generate and output a target row address (Row_ad) signal.

7. The internal error-checking circuit (10) according to claim 6, wherein the row-address generation circuit (133) comprises:
a row counting circuit (134), configured to receive the column end signal (Col_End) and perform row counting on the memory array (15) based on the column end signal (Col_End), generating and outputting a row count value (Row_cnt); and
a row-address sampling circuit (135), configured to receive the internal error-checking command signal (IMWRAB) and the row count value (Row_cnt) and sample the row count value (Row_cnt) in response to the internal error-checking command signal (IMWRAB), generating and outputting the target row address (Row_ad) signal.

8. The internal error-checking circuit (10) according to claim 6, wherein
the address generation circuit (13) further comprises a refresh-address generation circuit (136), configured to receive the internal self-refresh command signal (IREFAB) and perform row counting on the memory array (15) based on the internal self-refresh command signal (IREFAB) to generate and output a self-refresh address (SREF_Row); and
the control logic circuit (14) is further configured to: control the execution of a single refresh operation on all the memory arrays (15) based on the self-refresh address (SREF_Row).

9. The internal error-checking circuit (10) according to claim 6, wherein
the column-address generation circuit (131) comprises N cascaded first flip-flops (DFF1), N being an integer greater than or equal to one, wherein a clock control terminal of the first flip-flop (DFF1) in a first stage serves as an input terminal of the column-address generation circuit (131) and receives the internal error-checking command signal (IMWRAB); an inverted output terminal of the first flip-flop (DFF1) in each stage is connected to a data input terminal of the first flip-flop;
clock control terminals of the other first flip-flops (DFF1), except for the first flip-flop (DFF1) in the first stage, are each connected to an inverted output terminal of the first flip-flop (DFF1) in a preceding stage; non-inverted output terminals of the N first flip-flops (DFF1) collectively output the target column address (Col_ad); and
the first decoding circuit (132) comprises a first NAND gate (137), wherein N input terminals of the first NAND gate (137) are respectively connected to the non-inverted output terminals of the N first flip-flops (DFF1), and an output terminal of the first NAND gate (137) is configured to output the column end signal (Col_End).

10. The internal error-checking circuit (10) according to claim 7, wherein
the row counting circuit (134) comprises M cascaded second flip-flops (DFF2), M being an integer greater than or equal to one, wherein a clock control terminal of the second flip-flop (DFF2) in a first stage serves as an input terminal of the row counting circuit (134) and receives the column end signal (Col_End); an inverted output terminal of the second flip-flop (DFF2) in each stage is connected to a data input terminal of the second flip-flop; clock control terminals of the other second flip-flops (DFF2), except for the second flip-flop (DFF2) in the first stage, are each connected to an inverted output terminal of the second flip-flop (DFF2) in a preceding stage; non-inverted output terminals of the M second flip-flops (DFF2) collectively output the row count value (Row_cnt); and
the row-address sampling circuit (135) comprises M third flip-flops (DFF3), wherein a clock control terminal of each of the M third flip-flops (DFF3) receives the internal error-checking command signal (IMWRAB); data input terminals of the M third flip-flops (DFF3) are connected to the non-inverted output terminals of the M second flip-flops (DFF2) in a one-to-one correspondence manner to receive the row count value (Row_cnt); non-inverted output terminals of the M third flip-flops (DFF3) collectively output the target row address (Row_ad).

11. The internal error-checking circuit (10) according to claim 2, wherein the memory array control circuit (141) comprises:
a flag signal generation circuit (142), configured to receive the internal error-checking command signal (IMWRAB) and generate and output an operation flag signal (IMWR_FLAG) at an active level in response to the internal error-checking command signal (IMWRAB); and
a read/write command generation circuit (143), configured to receive the operation flag signal (IMWR_FLAG) and the internal error-checking command signal (IMWRAB) and sequentially generate, in response to the internal error-checking command signal (IMWRAB), a plurality of sets of internal signals (IRD/IWR) while the operation flag signal (IMWR_FLAG) is at the active level, wherein
the flag signal generation circuit (142) is further configured to: receive the internal write signal (IWR) and set the operation flag signal (IMWR_FLAG) to an inactive level when a count value (IWR_cnt) of the internal write signal (IWR) reaches a second preset value.

12. The internal error-checking circuit (10) according to claim 11, wherein the flag signal generation circuit (142) comprises:
a command counting circuit (144), configured to count an inversion signal of the internal write signal (IWR) to generate and output the count value (IWR_cnt) of the internal write signal (IWR);
a second decoding circuit (145), configured to receive the count value (IWR_cnt) of the internal write signal (IWR), and generate and output an operation end signal (IMWR_END) when the count value (IWR_cnt) of the internal write signal (IWR) is the second preset value; and
an SR flip-flop (146), configured to receive the internal error-checking command signal (IMWRAB) and the operation end signal (IMWR_END), set the operation flag signal (IMWR_FLAG) to an active level in response to the internal error-checking command signal (IMWRAB), and set the operation flag signal (IMWR_FLAG) to an inactive level when the count value (IWR_cnt) of the internal write signal (IWR) reaches the second preset value.

13. The internal error-checking circuit (10) according to any one of claims 11 to 12, wherein the read/write command generation circuit (143) comprises:
a second NAND gate (1431), wherein a first input terminal of the second NAND gate (1431) receives the operation flag signal (IMWR_FLAG), and a second input terminal of the second NAND gate (1431) receives the internal error-checking command signal (IMWRAB);
a first NOR gate (1432), wherein a first input terminal of the first NOR gate (1432) is electrically connected to an output terminal of the second NAND gate (1431), and an output terminal of the first NOR gate (1432) is configured to output the internal read signal (IRD);
a second NOR gate (1433), wherein a first input terminal of the second NOR gate (1433) is electrically connected to the output terminal of the first NOR gate (1432), and an output terminal of the second NOR gate (1433) is electrically connected to a second input terminal of the first NOR gate (1432);
a delay unit (1434), wherein an input terminal of the delay unit (1434) is electrically connected to the output terminal of the first NOR gate (1432);
a first NOT gate (1435), wherein an input terminal of the first NOT gate (1435) is electrically connected to an output terminal of the delay unit (1434), and an output terminal of the first NOT gate (1435) is electrically connected to a second input terminal of the second NOR gate (1433);
a second NOT gate (1436), wherein an input terminal of the second NOT gate (1436) receives the operation flag signal (IMWR_FLAG); and
a third NOR gate (1437), wherein a first input terminal of the third NOR gate (1437) is electrically connected to an output terminal of the second NOT gate (1436), a second input terminal of the third NOR gate (1437) is electrically connected to the output terminal of the first NOR gate (1432), and an output terminal of the third NOR gate (1437) is configured to output the internal write signal (IWR).

14. The internal error-checking circuit (10) according to any one of claims 11 to 13, wherein the memory array control circuit (141) further comprises:
a self-refresh control circuit (147), configured to receive the operation flag signal (IMWR_FLAG) and a self-refresh address (SREF_Row) and control, when the operation flag signal (IMWR_FLAG) flips to an inactive level, the corresponding memory array (15) to execute a single refresh operation based on the self-refresh address (SREF_Row).

15. The internal error-checking circuit (10) according to any one of claims 1 to 14, wherein
the error correction circuit (16) is further configured to: generate and output, when executing the internal read-modify-write operation on the target memory cell, an error flag signal if there is an error in the stored data of the target memory cell; and
the internal error-checking circuit (10) further comprises: an error register (17), configured to receive the internal error-checking address (IMWR_AD) and the error flag signal and store the internal error-checking address (IMWR_AD) in response to the error flag signal.

16. A memory (20), comprising the internal error-checking circuit (10) according to any one of claims 1 to 15.
